(19) Europäisches Patentamt
European Patent Office
Office européen des brevets

(11) **EP 3 477 808 B1**

(12) **EUROPÄISCHE PATENTSCHRIFT**

(45) Veröffentlichungstag und Bekanntmachung des Hinweises auf die Patenterteilung:
**16.08.2023 Patentblatt 2023/33**

(21) Anmeldenummer: **17197997.4**

(22) Anmeldetag: **24.10.2017**

(51) Internationale Patentklassifikation (IPC):
**H02H 3/30** *(2006.01)*     **H02H 7/26** *(2006.01)*
**G01R 31/08** *(2020.01)*

(52) Gemeinsame Patentklassifikation (CPC):
**H02H 7/265; G01R 31/58; H02H 3/305;**
G01R 31/085; G01R 31/086

(54) **VERFAHREN, SCHUTZGERÄT UND SCHUTZSYSTEM ZUM ERKENNEN EINES FEHLERS AUF EINER LEITUNG EINES ELEKTRISCHEN ENERGIEVERSORGUNGSNETZES**

METHOD, SAFETY DEVICE AND SAFETY SYSTEM FOR DETECTING A FAULT ON A LINE OF AN ELECTRICAL ENERGY SUPPLY NETWORK

PROCÉDÉ, APPAREIL DE PROTECTION ET SYSTÈME DE PROTECTION PERMETTANT DE RECONNAÎTRE UN DÉFAUT SUR UNE LIGNE D'UN RÉSEAU D'ALIMENTATION ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.05.2019 Patentblatt 2019/18**

(73) Patentinhaber: **Siemens Aktiengesellschaft 80333 München (DE)**

(72) Erfinder:
• **Dzienis, Cezary**
  **14624 Dallgow-Döberitz (DE)**
• **Jurisch, Andreas**
  **16727 Schwante (DE)**

(74) Vertreter: **Siemens Patent Attorneys**
  **Postfach 22 16 34**
  **80506 München (DE)**

(56) Entgegenhaltungen:
**US-A1- 2015 233 976     US-A1- 2017 199 237**

**Beschreibung**

Die Erfindung betrifft ein Verfahren zum Erkennen eines Fehlers auf einer Leitung eines elektrischen Energieversorgungsnetzes, bei dem an einem ersten Leitungsende der Leitung erste Stromwerte gemessen werden, zumindest an einem weiteren Leitungsende der Leitung weitere Stromwerte gemessen werden und unter Verwendung der ersten und der weiteren Stromwerte überprüft wird, ob auf der Leitung ein Fehler vorliegt. Die Erfindung betrifft darüber hinaus ein Schutzgerät zum Erkennen eines Fehlers auf einer Leitung eines elektrischen Energieversorgungsnetzes sowie ein entsprechendes Schutzsystem.

Ein Verfahren der eingangs genannten Art sowie ein entsprechendes Schutzgerät sind beispielsweise aus der EP 1 236 259 B1 bekannt, die ein sogenanntes Differentialschutzverfahren für Leitungen in Energieversorgungsnetzen beschreibt. Der Differentialschutz ist eines der selektivsten bekannten Schutzverfahren. Hier wird eine Leitung mit zwei oder mehr Enden auf Fehlerfreiheit überwacht und im Fall eines Fehlers ein Fehlersignal erzeugt, um die Leitung vom restlichen Netz zu trennen. Als Überwachungskriterium wird der Kirchhoffsche Knotenpunktsatz verwendet. Die Summe der in eine Leitung hinein- und auf der anderen Seite herausfließenden Ströme muss für eine fehlerfreie Leitung idealerweise Null ergeben. Ist das nicht mehr der Fall, ist die Leitung fehlerbehaftet und wird vom Netz getrennt.

Ein Hauptanwendungsfall des Differentialschutzes ist der strombasierte Differentialschutz. Hierbei werden die an den Leitungsenden gemessenen Ströme vorzeichenrichtig aufsummiert und die resultierende Stromsumme mit einem Differenzstrom-Schwellenwert verglichen. Bei einer Schwellenwertüberschreitung wird das Fehlersignal erzeugt. Um eine bessere Stabilität des Verfahrens bei Bildung der Stromdifferenzen zu ermöglichen, wird üblicherweise aus den Stromsignalen nur die Grundwellenkomponente als komplexer Zeiger verwendet. Damit kann ein Einfluss einer unterschiedlichen Übertragung der Gleichstrom-Komponente durch zur Strommessung an der Leitung eingesetzte Primärwandler weitgehend eliminiert werden. Ein Nachteil der Verwendung des Grundwellenzeigers ist jedoch, dass für die Bestimmung des Grundwellenzeigers Messwerte über eine Periodendauer des Stromsignals aufgenommen werden müssen. Damit kann die Auslösezeit eines derartigen StromDifferentialschutzes nicht unter einer Periodendauer des Grundwellensignals (z.B. 20ms bei 50Hz) liegen.

Bei der Strommessung mit analogen Stromwandlern besteht zudem die Möglichkeit einer sogenannten Wandlersättigung. Hierdurch werden die vom Wandler übertragenen Stromsignale besonders durch im Primärstrom enthaltende Gleichstrom-Komponenten nach einer sättigungsfreien Zeit so verfälscht, dass die vom Differentialschutz gebildete Stromsumme auch bei einer fehlerfreien Leitung einen Wert ungleich Null ergibt und damit eine Überfunktion (Abschaltung einer fehlerfreien Leitung) verursachen würde. Das Schutzprinzip des Stromdifferentialschutzes kann deshalb nur dann eingesetzt werden, wenn die sättigungsfreie Zeit der Wandler größer ist, als die Auslösezeit des Differentialschutzes und gleichzeitig eine Sättigungserkennung der Wandler für eine Blockierung des Differentialschutzes im Fall einer Wandlersättigung sorgt.

Ein vergleichsweise schnelles Differentialschutz-Prinzip sieht vor, dass anstelle der Ströme Ladungen gemessen werden und eine Fehlererkennung anhand von Momentanwerten der Ladung durchgeführt wird. Ein solches Ladungs-Differentialschutzverfahren ist beispielsweise aus der oben bereits genannten EP 1 236 259 B1 bekannt. Oftmals sind die bei solchen ladungsbasierten Differentialschutzverfahren verwendeten Schwellenwerte jedoch relativ unempfindlich eingestellt, so dass stromschwache Fehler nur schwer erkannt werden können.

Ausgehend von einem Verfahren und Schutzgerät der eingangs genannten Art liegt der Erfindung die Aufgabe zugrunde, eine Überwachung einer Leitung eines Energieversorgungsnetzes derart durchzuführen, dass Fehler vergleichsweise schnell und empfindlich erkannt werden können.

Zur Lösung dieser Aufgabe wird ein Verfahren gemäß Patentanspruch 1 vorgeschlagen. Danach wird ein Verfahren der eingangs genannten Art derart weitergebildet, dass an dem ersten Leitungsende der Leitung erste Spannungswerte und an dem zumindest einen weiteren Leitungsende der Leitung weitere Spannungswerte gemessen werden. Mit den an dem ersten Leitungsende gemessenen ersten Strom- und Spannungswerten werden erste Vergleichs-Stromwerte ermittelt, die den an einem Vergleichs-Ort auf der Leitung fließenden Strom angeben. Als Vergleichs-Ort kann ein beliebiger Punkt auf der Leitung zwischen den Leitungsenden gewählt werden. Es bietet sich z.B. an, als Vergleichs-Ort die Mitte der Leitung oder eines der Leitungsenden zu wählen. Mit den an dem zumindest einen weiteren Leitungsende gemessenen weiteren Strom- und Spannungswerten werden weitere Vergleichs-Stromwerte ermittelt, die den an dem Vergleichs-Ort auf der Leitung fließenden Strom angeben. Unter Verwendung der ersten und der weiteren Vergleichs-Stromwerte wird das Vorliegen eines Fehlers auf der Leitung überprüft und ein Fehlersignal wird erzeugt, wenn bei der Überprüfung ein auf der Leitung vorliegender Fehler erkannt worden ist.

Dadurch dass unter Verwendung von Strom- und Spannungswerten von den Enden der Leitung für einen auf der Leitung liegenden Vergleichs-Ort Vergleichs-Ströme bestimmt werden, kann sehr schnell und empfindlich erkannt werden, ob ein Fehler auf der Leitung vorliegt. Die Vergleichs-Ströme stimmen nämlich nur für den fehlerfreien Fall der Leitung überein, während bei einem vorliegenden Fehler eine signifikante Abweichung auftritt. Hierdurch kann schneller als bei Strom-Differentialschutzsystemen, die mit Grundwellenzeigern arbeiten, eine Entscheidung über das Vorliegen eines Fehlers getroffen werden .

Außerdem ist aus der EP 3 477 808 A1 ein Verfahren zur Fehlererkennung bekannt, bei dem an den Leitungsenden bestimmte Wanderwellen verwendet werden.

Außerdem verringert sich aufgrund der kurzen für die Entscheidung benötigten Zeit, die Gefahr einer Wandlersättigung, da die Entscheidung über das Vorliegen eines Fehlers meist schon in der sogenannten sättigungsfreien Zeit des Wandlers, beispielsweise kürzer als 3ms, getroffen werden kann.

Insbesondere auf langen Leitungen (z.B. Leitungen ab 50km Länge) entstehen signifikante kapazitive Ableitströme. Diese Ableitströme können mehr als 10% des Leitungs-Nennstroms betragen und erscheinen in der Stromsumme des Differentialschutzes als Differenz. Um eine Fehlauslösung des StromDifferentialschutzes aufgrund der Ableitströme zu vermeiden, wird beim klassischen Strom-Differentialschutz die Auslöseschwelle um den Betrag der Ableitströme erhöht und damit die Empfindlichkeit des Schutzes. Sehr hochohmige Fehler können damit von diesem klassischen Schutzprinzip nicht mehr erfasst werden.

Weitere auf Wanderwellen basierten Differentialschutzverfahren für Energieversorgungsnetze sind aus US 2015/233976 und US 2017/199237 bekannt.

Daher wird gemäß dem erfindungsgemässen Verfahren vorgeschlagen, dass zur Bestimmung der Vergleichs-Stromwerte ein mathematisches Modell der Leitung für den fehlerfreien Fall herangezogen wird.

Ein solches mathematisches Modell berücksichtigt bereits den Anteil der kapazitiven Ableitströme, so dass diese nicht das Ergebnis verfälschen können und durch eine unempfindlichere Einstellung kompensiert werden müssen.

Konkret ist in diesem Zusammenhang gemäß dem erfindungsgemässen Verfahren vorgesehen, dass die Vergleichs-Stromwerte unter Verwendung der ersten und der weiteren Strom- und Spannungswerte sowie des mathematischen Modells der Leitung geschätzt werden, wobei zur Schätzung die Ausbreitung von Wanderwellen ("Traveling Waves") entlang der Leitung betrachtet wird. Vorteilhaft wird hierbei die Theorie der Ausbreitung von Wanderwellen entlang der Leitung ausgenutzt, um anhand der an den Leitungsenden gemessenen Strom- und Spannungswerte auf den Vergleichs-Strom am Vergleichs-Ort zu schließen. Auf diese Weise kann bei Kenntnis von Leitungsparametern der fehlerfreien Leitung, wie z.B. einer Ausbreitungskontanten bzgl. der Ausbreitung von Wanderwellen entlang der Leitung und einer Wellenimpedanz, unter Verwendung eines für die Ausbreitung von Wanderwellen gültigen mathematischen Leitungsmodells eine Bestimmung der Vergleichs-Stromwerte vorgenommen werden. Da das Verfahren durch das eingesetzte Wanderwellen-Leitungsmodell die kapazitiven Ableitströme in der Berechnung des transienten Stroms am gemeinsamen Vergleichs-Ort berücksichtigt, wird der Nachteil der Unempfindlichkeit durch kapazitive Ladeströme vermieden.

Die Betrachtung von Wanderwellen im Zusammenhang mit Energieversorgungsnetzen wird bisher klassischerweise für die Fehlerortung nach einem aufgetretenen Fehler eingesetzt. Die Verwendung zu Zwecken des Differentialschutzes zur Erkennung und Abschaltung eines Fehlers ist jedoch bisher nicht bekannt.

Konkret ist in diesem Zusammenhang vorgesehen, dass zur Schätzung der Vergleichs-Stromwerte die ersten und die weiteren Strom- und Spannungswerte einer Filterung unterzogen werden, wobei mit dem Filter eine zumindest von der Ausbreitungskonstante einer Wanderwelle entlang der Leitung und/oder eine von der Wellenimpedanz der Leitung abhängige Übertragungsfunktion nachgebildet wird.

Hierdurch lassen sich mit vergleichsweise niedrigem Rechenaufwand durch geeignete Filterung der Strom- und Spannungswerte die gesuchten Vergleichs-Stromwerte ermitteln, indem die Ausbreitungskonstante auf der Leitung und/oder die Wellenimpedanz der Leitung berücksichtigt werden. Beispiele für geeignete digitale Filter sind sogenannte "FIR-Filter" (FIR = Finite Impulse Response) und "IIR-Filter" (IIR = Infinite Impulse Response).

Eine weitere vorteilhafte Ausführungsform des erfindungsgemäßen Verfahrens sieht vor, dass unter Verwendung der ersten und der weiteren Vergleichs-Stromwerte eine Fehlergröße gebildet und ein Fehler auf der Leitung erkannt wird, wenn die Fehlergröße einen vorgegebenen Schwellenwert überschreitet.

Auf diese Weise kann durch Anwendung eines einzelnen Kriteriums sehr schnell erkannt werden, ob ein Fehler auf der Leitung vorliegt. Bevorzugt kann die Fehlergröße einerseits eine Haltekomponente, die zumindest eine Summe der Effektivwerte der von den Leitungsenden aus bestimmten Vergleichs-Stromwerte beinhaltet, und andererseits eine Auslösekomponente umfassen, die eine durch vorzeichenrichtige Addition der einzelnen Vergleichs-Ströme gebildete Summe beinhaltet. Diese Auslösekomponente nimmt im Normalfall einen Wert nahe Null an. Durch Vergleich der Auslösekomponente mit der Haltekomponente kann eine Entscheidung über das Vorliegen eines Fehlers getroffen werden. Beispielsweise kann hierfür die ermittelte Fehlergröße mit einem Schwellenwert verglichen werden. Bei einer Schwellenwertüberschreitung wird ein vorliegender Fehler erkannt.

Die an den Leitungsenden zu messenden Ströme können nur indirekt über Stromwandler gemessen werden. Diese Stromwandler haben häufig ein Hochpass-Übertragungsverhalten, das typischerweise für die Messpunkte an den Enden der Leitung unterschiedlich ist. Besonders die bei einem Kurzschluss entstehenden Gleichstrom-Anteile werden von den Stromwandlern unterschiedlich übertragen, so dass durch das Übertragungsverhalten der Wandler eine Verfälschung der gemessenen Ströme entstehen kann.

Um dies weit möglichst zu vermeiden, ist gemäß einer weiteren vorteilhaften Ausführungsform des erfindungsgemäßen Verfahrens vorgesehen, dass die ersten und die weiteren Strom- und Spannungswerte einer Filterung mit einem Hochpassfilter unterzogen werden. Dadurch wird eine Dämpfung der Gleichstrom-Komponente auf ein vernachlässigbares Maß erreicht.

Eine weitere vorteilhafte Ausführungsform des erfindungsgemäßen Verfahrens sieht vor, dass die Ermittlung der Vergleichs-Stromwerte an jedem Leitungsende durchgeführt wird und die an den jeweiligen Leitungsenden ermittelten Vergleichs-Stromwerte zwischen den Leitungsenden über eine IP-basierte Datenkommunikation übertragen werden.

Gemäß dieser Ausführungsform werden die aus den lokalen Strom- und Spannungswerten für den gemeinsamen Vergleichs-Ort berechneten Vergleichs-Stromwerte über eine IP basierte Kommunikationsverbindung ausgetauscht.

Als besonders vorteilhaft wird es in diesem Zusammenhang angesehen, wenn bei einer mehr als zwei Leitungsenden aufweisenden Leitung die Übertragung der Vergleichs-Stromwerte zwischen den Leitungsenden mittels Multicast-Telegrammen erfolgt.

Auf diese Weise kann ein an einem Ende der Leitung bestimmter Vergleichs-Stromwert mittels eines Multicast-Telegramms gleichzeitig an die Schutzgeräte an allen anderen Enden gesendet werden, so dass keine dedizierten Telegramme für jedes Empfänger-Schutzgerät erforderlich sind.

Um die an den Leitungsenden bestimmten Vergleichs-Stromwerte einander zuordnen zu können, ist gemäß einer weiteren vorteilhaften Ausführungsform des erfindungsgemäßen Verfahrens vorgesehen, dass den Vergleichs-Stromwerten Zeitstempel zugeordnet werden.

Die Bestimmung der Strom- und Spannungswerte an den jeweiligen Leitungsenden, aus denen die jeweiligen Vergleichs-Stromwerte gebildet werden, muss an allen Enden der Leitung zum gleichen Zeitpunkt erfolgen. Ist das nicht der Fall, kann eine empfindliche Erkennung von Fehlern auf der Leitung nicht vorgenommen werden. Die Zeitsynchronisation der Differentialschutzgeräte untereinander muss hierbei über mehrere Kilometer lange Entfernungen gewährleistet werden können. Traditionell wurden für diese Anwendung dedizierte Kommunikationsverbindungen verwendet, über die die Messwerte mit deterministischen Laufzeiten übertragen wurden. Zur Zeitsynchronisation der Geräte wurden die Laufzeiten der Kommunikationsverbindungen eingemessen. Die verwendete Einmess-Methode setzt eine identische Laufzeit für den Hin- und Rückkanal der Kommunikationsverbindung voraus. Mit bekannter Laufzeit konnten die Datenfenster zur Erfassung der Messwerte ausreichend genau synchronisiert werden. Diese in herkömmlichen Systemen verwendeten dedizierten Kommunikationsverbindungen wurden durch den technischen Fortschritt der Kommunikationstechnik durch Kommunikationsnetzwerke abgelöst. In diesen Kommunikationsnetzwerken kann durch den Ausfall einer Kommunikationsstrecke ein anderer Weg durch das Netzwerk gewählt werden. Das führt zu einer sprunghaften Änderung der Laufzeit durch das Kommunikationsnetz. Wird diese Laufzeitänderung nicht erkannt, dann entsteht in mindestens einem der Differentialschutzgeräte eine falsche Positionierung des Datenfensters für die Messwerterfassung. Diese falsche Fensterposition kann zu einer Fehlauslösung des Differentialschutzes führen.

Daher wird gemäß einer weiteren vorteilhaften Ausführungsform des erfindungsgemäßen Verfahrens vorgeschlagen, dass die zur Zeitstempelung an den jeweiligen Leitungsenden verwendeten Zeitgeber mittels eines Zeitimpulses eines zentralen Zeitgebers oder eines Zeitsynchronisations-Protokolls, vorzugsweise PTP, synchronisiert werden.

Beispielsweise kann zur Synchronisation der Zeitgeber in den einzelnen Schutzgeräten ein Zeitimpuls des GPS-Systems verwendet werden. Alternativ kann auch ein Zeitsynchronisations-Protokoll verwendet werden, das ohne einen externen zentralen Zeitgeber auskommt, sondern über das Kommunikationsnetzwerk versendete Zeitsynchronisationsnachrichten verwendet. Ein Beispiel hierfür ist das Precision Time Protocol (PTP). Hierbei wird vorteilhaft zur Zeitsynchronisation der am Differentialschutz beteiligten Schutzgeräte das Precision Time Protocol (PTP) über die gleiche Kommunikationsverbindung verwendet, die auch zum Austausch der Vergleichs-Stromwerte verwendet wird. Vorteilhaft daran ist, dass die Zeitsynchronisation auch bei Ausfall eines externen Zeitgebers funktionsfähig bleibt.

Gemäß einer weiteren vorteilhaften Ausführungsform des erfindungsgemäßen Verfahrens wird vorgeschlagen, dass die Überprüfung, ob auf der Leitung ein Fehler vorliegt, an jedem Leitungsende durchgeführt wird.

Hierdurch kann erreicht werden, dass die Fehlererkennung redundant, nämlich in den Geräten an allen Leitungsenden, durchgeführt wird, so dass die Zuverlässigkeit der Fehlererkennung insgesamt steigt.

In diesem Zusammenhang wird es zudem als vorteilhaft angesehen, wenn an jedem Leitungsende Vergleichs-Stromwerte empfangen werden, die an den anderen Leitungsenden ermittelt worden sind, und die empfangenen Vergleichs-Stromwerte mit den lokal ermittelten Vergleichs-Stromwerten durch eine erneute Abtastung und eine anschließende Interpolation zeitlich aufeinander abgeglichen werden.

Hierdurch kann vorteilhaft sichergestellt werden, dass auch ohne eine zeitlich synchrone Messwerterfassung eine Angleichung der Messzeitpunkte aufeinander erfolgen kann. Hierbei werden nämlich solche Vergleichs-Stromwerte, die zu unterschiedlichen Zeitpunkten erfasst worden sind, durch erneute Abtastung und anschließende Interpolation auf einen gemeinsamen Messzeitpunkt umgerechnet.

Die oben genannte Aufgabe wird auch nach Anspruch 10 durch ein Schutzgerät zum Erkennen eines Fehlers auf einer Leitung eines elektrischen Energieversorgungsnetzes gelöst. Das Schutzgerät weist eine Messeinrichtung, die zur Erfassung von an einem ersten Leitungsende der Leitung gemessenen ersten Stromwerten eingerichtet ist, eine Kommunikationseinrichtung, die zum Empfang von zumindest an einem weiteren Leitungsende der Leitung gemessenen weiteren Stromwerten eingerichtet ist, und eine Auswerteinrichtung auf, die dazu eingerichtet ist, unter Verwendung der ersten und der weiteren Stromwerte zu überprüfen, ob auf der Leitung ein Fehler vorliegt. Erfindungsgemäß ist vorgesehen, dass die Messeinrichtung dazu eingerichtet ist, an dem ersten Leitungsende der Leitung gemessene erste Spannungswerte zu erfassen, dass die Kommunikationseinrichtung dazu eingerichtet ist, an dem zumindest einen weiteren Leitungsende der Leitung gemessene weitere Spannungswerte zu empfangen, und dass die Auswerteinrichtung dazu eingerichtet ist, mit den an dem ersten Leitungsende gemessenen ersten Strom- und Spannungswerten erste Vergleichs-Stromwerte zu ermitteln, die den an einem Vergleichs-Ort auf der Leitung fließenden Strom angeben, mit den an dem zumindest einen weiteren Leitungsende gemessenen weiteren Strom- und Spannungswerten weitere Vergleichs-Stromwerte zu ermitteln, die den an dem Vergleichs-Ort auf der Leitung fließenden Strom angeben, und unter Verwendung der ersten und der weiteren Vergleichs-Stromwerte das Vorliegen eines Fehlers auf der Leitung zu überprüfen und ein Fehlersignal zu erzeugen, wenn bei der Überprüfung auf der Leitung vorliegender Fehler erkannt worden ist.

Hinsichtlich des erfindungsgemäßen Schutzgerätes gelten alle zu dem erfindungsgemäßen Verfahren voranstehend und nachfolgend gemachten Ausführungen und umgekehrt in entsprechender Weise, insbesondere ist das erfindungsgemäße Schutzgerät zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Schutzgerätes wird auf die zu dem erfindungsgemäßen Verfahren beschriebenen Vorteile verwiesen. Schließlich wird die oben genannte Aufgabe auch durch ein Schutzsystem zum Erkennen eines Fehlers auf einer Leitung eines elektrischen Energieversorgungsnetzes gelöst, wobei das Schutzsystem mindestens zwei Schutzgeräte nach Anspruch 10 aufweist, die über eine Kommunikationsverbindung miteinander verbunden sind.

Bei einer Ausführungsform des erfindungsgemäßen Schutzsystems kann vorgesehen sein, dass das Schutzsystem zur Erkennung eines Fehlers auf einer Leitung mit mehr als zwei Enden eingerichtet ist und an jedem Ende der Leitung ein Schutzgerät vorgesehen ist, wobei alle Schutzgeräte miteinander über die Kommunikationsverbindung verbunden sind.

Hinsichtlich des erfindungsgemäßen Schutzsystems gelten alle zu dem erfindungsgemäßen Verfahren und dem erfindungsgemäßen Schutzgerät voranstehend und nachfolgend gemachten Ausführungen und umgekehrt in entsprechender Weise, insbesondere ist das erfindungsgemäße Schutzsystem zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Schutzsystems wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierbei zeigen

Figur 1    eine schematische Ansicht eines ersten Ausführungsbeispiels einer Leitung eines Energieversorgungsnetzes;

Figur 2    eine schematische Ansicht eines zweiten Ausführungsbeispiels einer Leitung eines Energieversorgungsnetzes;

Figur 3    eine Darstellung der elektrischen Parameter eines Leitungsabschnitts Δx zur Erläuterung der Ausbreitung eines Stromsignals nach dem Wanderwellenprinzip;

Figur 4    ein schematisches Blockschaltbild eines Ausführungsbeispiels eines elektrischen Schutzgerätes;

Figur 5    Verläufe von Strom und Spannung während eines Fehlers auf einer Leitung;

Figur 6    ein Logikdiagramm zur Erläuterung der Bestimmung eines Vergleichs-Stromwertes;

Figur 7    ein schematisches Blockschaltbild eines Ausführungsbeispiels eines elektrischen Schutzgerätes in detaillierterer Darstellung;

Figur 8    Diagramme von beispielhaften Stromverläufen ohne Filterung;

Figur 9    Diagramme von beispielhaften Stromverläufen mit Filterung; und

Figur 10    ein Logikdiagramm zur Erläuterung der Bestimmung einer Übertragungsfunktion eines digitalen Filters.

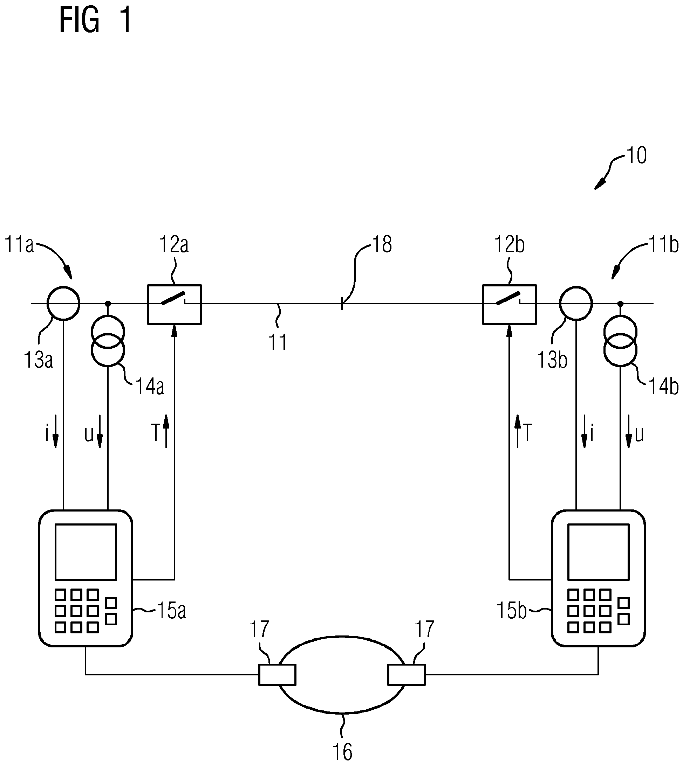

Figur 1 zeigt eine schematische Ansicht eines Schutzsystems 10 zum Erkennen eines Fehlers auf einer Leitung eines in Figur 1 nicht näher dargestellten elektrischen Energieversorgungsnetzes. Hierzu ist in Figur 1 eine elektrische Leitung 11 des Energieversorgungsnetzes in vereinfachter Darstellung gezeigt. Bei der Leitung 11 kann es sich um eine ein- oder eine mehrphasige Leitung handeln. Die Leitung 11 wird an ihren Leitungsenden 11a und 11b durch Leistungsschalter 12a, 12b begrenzt und kann durch diese, insbesondere im Fehlerfall, vom restlichen Energieversorgungsnetz abgetrennt werden. An den Leitungsenden 11a, 11b sind zudem Messstellen vorgesehen, an denen mit in Figur 1 lediglich beispielhaft dargestellten Stromwandlern 13a, 13b und Spannungswandlern 14a, 14b Strom- und Spannungswerte erfasst werden. Bei den Stromwandlern 13a, 13b und den Spannungswandlern 14a, 14b kann es sich um sogenannte konventionelle oder nicht konventionelle Wandler handeln. Sekundärseitig werden von den Wandlern Stromwerte i und Spannungswerte u abgegeben, bei denen es sich um analoge oder digitalisierte Werte handeln kann.

Mit den Stromwandlern 13a, 13b und den Spannungswandlern 14a, 14b stehen an den jeweiligen Leitungsenden 11a, 11b Schutzgeräte 15a, 15b zum Erkennen eines Fehlers auf der Leitung 11 in Verbindung. Die Schutzgeräte 15a, 15b erfassen mittels einer Messeinrichtung die Strom- und Spannungsmesswerte und führen ggf. eine Digitalisierung und/oder eine Vorverarbeitung durch. Dabei wird den jeweiligen Messwerten auch ein Zeitstempel zugeordnet, der den Zeitpunkt ihrer Erfassung genau angibt. Zu diesem Zweck weisen die Schutzgeräte 15a, 15b interne Zeitgeber auf, die untereinander mittels gängiger Verfahren, z.B. GPS-Zeitimpulsen, IRIG-B, Precision Time Protocol (PTP) gemäß IEEE 1588, zeitlich synchronisiert sind. Aufgrund der Zeitstempelung sind die an beiden Leitungsenden 11a, 11b aufgenommenen Messwerte miteinander vergleichbar.

Bei den Schutzgeräten 15a, 15b kann es sich beispielsweise um elektrische Differentialschutzgeräte handeln, die den Betriebszustand der Leitung 11 anhand der erfassten Strom- und Spannungswerte überwachen und im Fehlerfall ein Fehlersignal T an ihren jeweiligen Leistungsschalter 12a, 12b übermitteln, um diesen zum Öffnen seiner Schaltkontakte zu veranlassen.

Die Schutzgeräte 15a, 15b umfassen je eine Auswerteinrichtung, die jeweils dazu eingerichtet ist, die Leitung 11 auf einen Fehler (z.B. Kurzschluss, Erdschluss) zu überwachen. Außerdem weisen die Schutzgeräte 15a, 15b je eine Kommunikationseinrichtung auf, über die sie mittels einer Kommunikationsverbindung 16 miteinander verbunden sind. Bei der Kommunikationsverbindung 16 kann es sich um eine beliebige geeignete drahtgebundene oder drahtlose Kommunikationsverbindung in Form einer dedizierten Verbindung oder eine Kommunikationsnetzes handeln. Im Beispiel der Figur 1 ist die Kommunikationsverbindung 16 als Kommunikationsnetz ausgebildet, mit dem die Schutzgeräte über Netzwerkkomponenten 17, beispielsweise Router oder Switches verbunden sind. Über die Kommunikationsverbindung 16 können die Schutzgeräte 15a, 15b Datentelegramme austauschen, deren Inhalt zur Erkennung eines Fehlers auf der Leitung 11 herangezogen wird. Außerdem können sie über die Kommunikationsverbindung 16 Telegramme austauschen, die zur zeitlichen Synchronisation der Zeitgeber der Schutzgeräte dienen.

Zur Überwachung der Leitung 11 auf Fehler bestimmen die jeweiligen Schutzgeräte 15a, 15b unter Verwendung der an ihrem jeweiligen Leitungsende 11a, 11b gemessenen Strom- und Spannungswerte jeweilige Vergleichs-Stromwerte, die den an einem auf der Leitung gewählten Vergleichs-Ort 18 fließenden Strom angeben. Unter Heranziehung der von den unterschiedlichen Leitungsenden 11a, 11b bestimmten Vergleichs-Stromwerte kann schließlich auf einen etwaigen Fehler geschlossen werden. Sofern ein Fehler erkannt wird, gibt die Auswerteinrichtung 42 ein Fehlersignal F ab, das zur Ansteuerung des dem Schutzgerät 15a zugeordneten Leistungsschalters 12a verwendet werden kann. Außerdem kann das Fehlersignal auch über die Kommunikationseinrichtung an die anderen Schutzgeräte 15b, 15c übertragen werden, um dort die jeweiligen Leistungsschalter 12b, 12c auszulösen. Anstelle oder zusätzlich zu einer Leistungsschalterauslösung kann das Fehlersignal aber auch als Anregesignal für weitere Schutzapplikationen des Schutzgerätes 15a verwendet und/oder als Alarmsignal an einen Netzbetreiber ausgegeben werden. Die konkrete Vorgehensweise zur Erkennung eines vorliegenden Fehlers wird an späterer Stelle erläutert.

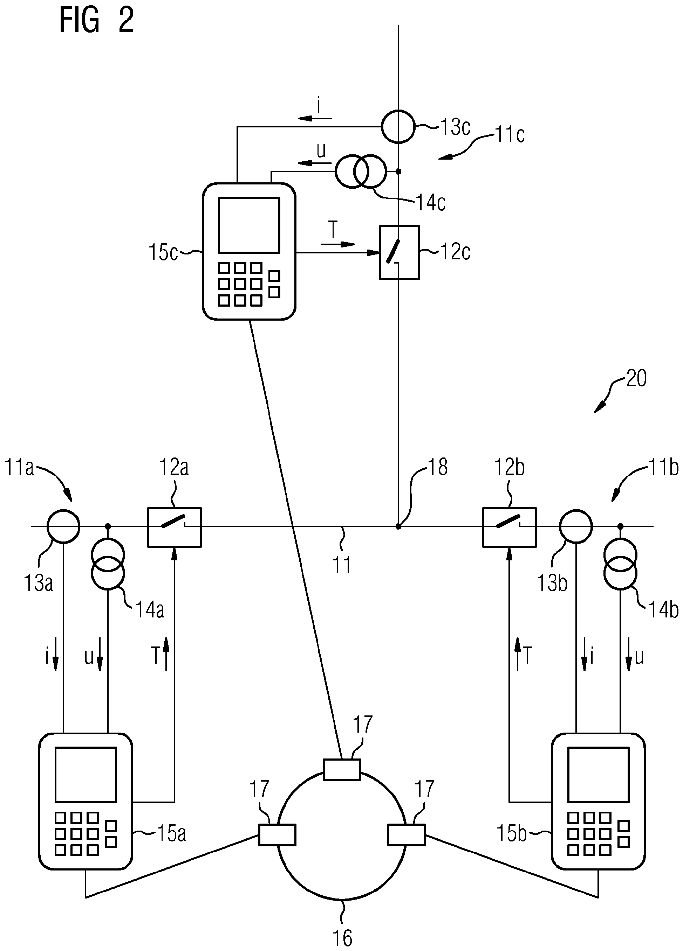

In Figur 2 ist ein anderes Ausführungsbeispiel eines Schutzsystems 20 gezeigt. Dabei sind einander entsprechende oder vergleichbare Komponenten mit denselben Bezugszeichen gekennzeichnet. Das Schutzsystem 20 gemäß Figur 2 unterscheidet sich von dem Schutzsystem 10 der Figur 1 insbesondere dadurch, dass die Leitung 11 anstelle von zwei nunmehr drei Enden 11a, 11b, 11c aufweist. Auch am dritten Leitungsende 11c ist ein Leistungsschalter 12c vorgesehen, mit dem die Leitung 11 vom restlichen Energieversorgungsnetz abgetrennt werden kann. Dazu ist am Ende 11c zudem ein Schutzgerät 15c vorgesehen, das an dem Leitungsende 11c gemessene Strom- und Spannungswerte auswertet und im Fehlerfall ein Fehlersignal T erzeugt, um den Leistungsschalter 12c zum Öffnen seiner Kontakte zu veranlassen. Darüber hinaus ist auch das Schutzgerät 15c über eine Netzwerkkomponente 17 mit der Kommunikationsverbindung 16 verbunden. Die Schutzgeräte 15a, 15b, 15c sind untereinander über die Kommunikationsverbindung 16, die gemäß Figur 2 als Kommunikationsnetz ausgebildet ist, verbunden.

Mit den Schutzgeräten 15a, 15b, 15c werden unter Verwendung der an ihrem jeweiligen Leitungsende 11a, 11b, 11c gemessenen Strom- und Spannungswerte jeweilige Vergleichs-Stromwert bestimmt, die den an einem gemeinsamen Vergleichs-Ort 18 fließenden Strom angeben. Als Vergleichs-Ort 18 ist im Bespiel der Figur 2 der Knotenpunkt gewählt, an dem die drei Leitungsenden aufeinander stoßen. Anhand der Vergleichs-Stromwerte aller Leitungsenden kann auf das Vorliegen eines Fehlers geschlossen werden.

Die Schutzgeräte 15a, 15b und 15c der Figuren 1 und 2 können bei der Erkennung von Fehlern das sogenannte Wanderwellenprinzip anwenden. Dabei wird ausgenutzt, dass sich ein Stromsignal etwa mit Lichtgeschwindigkeit auf der Leitung 11 ausbreitet. Somit kann bei Kenntnis des Stroms und der Spannung an einer Stelle der Leitung auf den Strom an einer anderen Stelle der Leitung geschlossen werden. Nachfolgend wird eine Vorgehensweise zur empfindlichen Fehlererkennung beschrieben. Zunächst soll hierzu eine kurze Erläuterung des Prinzips der Wanderwellen gegeben werden. Dabei wird ein Ausbreitungsmodell für Wanderwellen entlang der Leitung 11 verwendet.

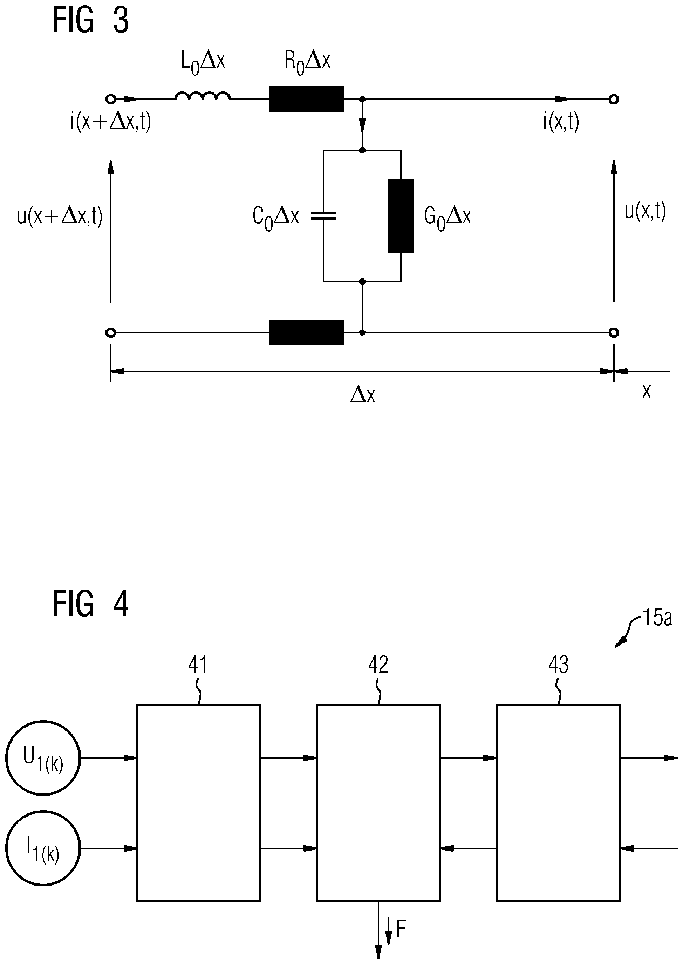

Zur Aufstellung des fraglichen Algorithmus wird die "Theorie der Langen Leitungen" eingesetzt. Es handelt sich hierbei um die modellhafte Abbildung einer elektrischen Leitung in Form von sogenannten "verteilten Parametern". Dies ist beispielhaft in Figur 3 dargestellt.

Der Figur 3 ist zu entnehmen, dass die Netzparameter wie Induktivitätsbelag $L_0$, Kapazitätsbelag $C_0$, Widerstandsbelag $R_0$ sowie Konduktivitätsbelag $G_0$ längs der Leitung verteilt sind. Basierend auf diesem Leitungsmodell können unter Verwendung von Kirchhoffschen-Gesetzen für das Teilstück $\Delta x$ der Leitung folgende Gleichungen für die Spannung u und den Strom i aufstellt werden:

$$u(x + \Delta x, t) = R_0 \Delta x \cdot i(x + \Delta x, t) + L_0 \Delta x \frac{\partial i(x + \Delta x, t)}{\partial t} + u(x, t) \qquad (1)$$

$$i(x + \Delta x, t) = G_0 \Delta x \cdot u(x, t) + C_0 \Delta x \frac{\partial u(x, t)}{\partial t} + i(x, t) \qquad (2)$$

Durch mathematische Umformungen lassen sich die Gleichungen (1) und (2) in die folgende Form überführen:

$$\frac{\partial u(x, t)}{\partial x} = R_0 \cdot i(x, t) + L_0 \frac{\partial i(x, t)}{\partial t} \qquad (3)$$

$$\frac{\partial i(x, t)}{\partial x} = G_0 \cdot u(x, t) + C_0 \frac{\partial u(x, t)}{\partial t} \qquad (4)$$

Diese Gleichungen (3) und (4) sind partielle Differentialgleichungen einer homogenen Leitung und werden üblicherweise als "Telegraphengleichungen" bezeichnet. Sie lassen sich auf beliebige Anzahlen von Leitern verallgemeinern.

Durch die Betrachtung der Gleichungen (3) und (4) im Laplace-Bereich unter der Annahme von x als Parameter (Entfernung des Vergleichs-Ortes von der Messstelle) lassen sich viele in der Leitung entstehende Effekte wesentlich einfacher interpretieren:

$$\frac{\partial u(x, s)}{\partial x} = R_0 \cdot i(x, s) + sL_0 \cdot i(x, s) \qquad (5)$$

$$\frac{\partial i(x, s)}{\partial x} = G_0 \cdot u(x, s) + sC_0 \cdot u(x, s) \qquad (6)$$

Die Ableitung der Gleichungen (5) und (6) nach Parameter x ergibt:

$$\frac{\partial^2 u(x, s)}{\partial x^2} = Z(s) Y(s) \cdot u(x, s) \qquad (7)$$

$$\frac{\partial^2 i(x,s)}{\partial x^2} = Y(s)Z(s) \cdot i(x,s) \tag{8}$$

Gleichungen (7) und (8) lassen sich unter Verwendung der Differentialgleichungstheorie für Spannung und Strom separat lösen:

$$U(x) = e^{-\gamma(s)x} \cdot A_1 + e^{\gamma(s)x} \cdot A_2 \tag{9}$$

$$Z_c(s) \cdot I(x) = e^{-\gamma(s)x} \cdot A_1 - e^{\gamma(s)x} \cdot A_2 \tag{10}$$

Bei der Lösung der Gleichungen (9) und (10) ist es möglich, die unbekannten Parameter $A_1$ und $A_2$ von den Anfangsbedingungen auszurechnen:

$$A_1 = \frac{1}{2}\left(U_1(s) + Z_c(s) \cdot I_1(s)\right) \tag{11}$$

$$A_2 = \frac{1}{2}\left(U_1(s) - Z_c(s) \cdot I_1(s)\right) \tag{12}$$

wobei $U_1$ und $I_1$ die Anfangsbedingungen bei x=0 darstellen.

Darüber hinaus beinhalten Gleichungen (9) und (10) eine sogenannte Wellenimpedanz $Z_C$ und die Ausbreitungskonstante y, die sich aus den Leitungsparametern berechnen lassen:

$$\gamma(s)^2 = Z(s)Y(s) \tag{13}$$

$$Z_c(s) = \gamma(s)^{-1} \cdot Z(s) \tag{14}$$

Hierbei steht Z für die Längsimpedanz und Y für die Queradmittanz eines Abschnitts der Leitung. Die Werte werden jeweils längenbezogen angegeben.

Somit ergeben sich für die Gleichungen (9) und (10) folgende Formen:

$$U(x,s) = \frac{1}{2}e^{-\gamma(s)x} \cdot \left(U_1(s) + Z_c(s) \cdot I_1(s)\right) + \frac{1}{2}e^{\gamma(s)x} \cdot \left(U_1(s) - Z_c(s) \cdot I_1(s)\right) \tag{15}$$

$$Z_c(s) \cdot I(x,s) = \frac{1}{2}e^{-\gamma(s)x} \cdot \left(U_1(s) + Z_c(s) \cdot I_1(s)\right) - \frac{1}{2}e^{\gamma(s)x} \cdot \left(U_1(s) - Z_c(s) \cdot I_1(s)\right) \tag{16}$$

Gleichungen (15) und (16) stellen ein spannungs- bzw. strombezogenes Ausbreitungsmodell für Wanderwellen entlang der Leitung 11 dar, das zur Bestimmung von Vergleichs-Strömen an einem Vergleichs-Ort nach der Wanderwellenmethode eingesetzt werden kann.

Anhand von Figur 4 soll an einem möglichen Beispiel die Vorgehensweise zur Fehlererkennung erläutert werden. Figur 4 zeigt hierzu ein schematisches Blockschaltbild eines Ausführungsbeispiels eines Schutzgerätes, beispielsweise des Schutzgerätes 15a (vgl. Figuren 1 und 2), zum Erkennen eines Fehlers auf einer Leitung. Die anderen Schutzgeräte 15b, 15c sind entsprechend aufgebaut.

Das Schutzgerät 15a weist eine Messeinrichtung 41, eine Auswerteinrichtung 42 und eine Kommunikationseinrichtung 43 auf. Bei der Auswerteinrichtung 42 kann es sich z.B. um einen Mikroprozessor handeln, der auf eine entsprechende Gerätesoftware zugreift, die sich in einem Speicher des Schutzgerätes 15a befindet. Alternativ kann es sich auch um einen Rechenbaustein mit hardwarebestimmter Programmierung handeln, z.B. einen ASIC oder FPGA.

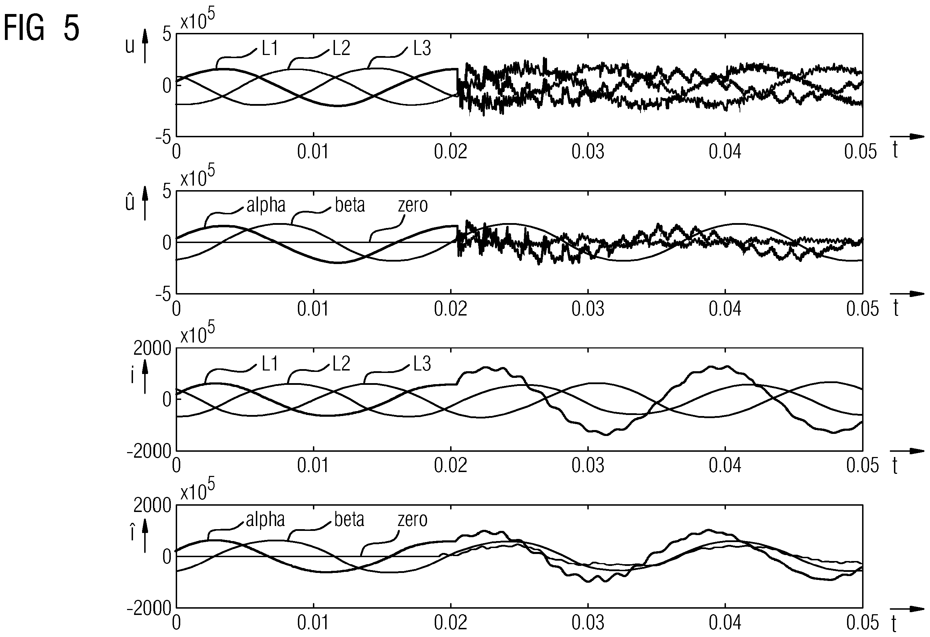

Zunächst werden mittels der Messeinrichtung 41 die an dem entsprechenden Leitungsende 11a vorliegenden lokalen Ströme und Spannungen gemessen und entsprechende Strom- und Spannungswerte erzeugt. Diese Messwerte werden in Abtastwerte der Strom- und Spannungssignale umgesetzt. Ein Beispiel für die erfassten Strom- und Spannungsmesswerte ist in Figur 5 ersichtlich; man erkennt einen Fehlereintritt bei etwa t=0,02s.

In Falle von dreiphasigen Energieversorgungsnetzen können zudem optional die jeweiligen Signale durch eine Transformation (z.B. Clarke-Transformation, bei der die Signale in "alpha", "beta" und "zero" Komponenten ausgedrückt werden) behandelt werden, z.B. um die phasenbezogenen Anteile zu entkoppeln. Die entstehenden Signale sind ebenfalls in Figur 5 gezeigt. Die Transformation kann in der Messeinrichtung 41 oder in der nachgeschalteten Auswerteinrichtung 42 stattfinden.

Falls die nachfolgende Auswertung im Frequenzbereich stattfinden soll, kann eine Überführung der transformierten Strom- und Spannungswerte in den Frequenzbereich stattfinden. Dies erfolgt bevorzugt mittels einer Fast Fourier Transformation (FFT) bzw. Discrete Fourier Transformation (DFT).

Mittels der Auswerteinrichtung 42 findet zudem unter Verwendung der - ggf. transformierten und in den Frequenzbereich umgesetzten - Strom- und Spannungswerte eine Bestimmung von Vergleichs-Stromwerten statt, die den Strom auf der Leitung an einem vorgewählten Vergleichs-Ort (Entfernung x von der Messstelle) auf der Leitung angeben. Der lokal bestimmte Vergleichs-Strom wird einerseits für die Fehlererkennung in der Auswerteinrichtung verwendet und andererseits über die Kommunikationseinrichtung 43 an die Kommunikationsverbindung 16 (vgl. Figuren 1 und 2) abgegeben.

Über die Kommunikationsverbindung 16 tauschen alle Schutzgeräte 15a, 15b, 15c (vgl. Figuren 1 und 2) untereinander die jeweils lokal bestimmten Vergleichs-Stromwerte aus. Bei Kenntnis der Vergleichs-Stromwerte aller Leitungsenden kann die Fehlererkennung in den Auswerteinrichtungen der einzelnen Schutzgeräte 15a, 15b, 15c durchgeführt werden.

Nachfolgend wird eine Vorgehensweise erläutert, mit der anhand der lokal gemessenen Strom- und Spannungswerte die Vergleichs-Stromwerte bestimmte werden können.

Durch Umstellung der Gleichungen (15) und (16), wobei als Bezugsort der Beginn der Leitung und als Vergleichs-Ort $x_0$ gewählt wird, entsteht folgender Gleichungssatz (17):

$$\begin{pmatrix} U_{x0}(s) \\ I_{x0}(s) \end{pmatrix} = \begin{pmatrix} \cosh(\gamma(s) \cdot x_0) & Z_c(s) \cdot \sinh(\gamma(s) \cdot x_0) \\ \dfrac{1}{Z_c(s)} \cdot \sinh(\gamma(s) \cdot x_0) & \cosh(\gamma(s) \cdot x_0) \end{pmatrix} \cdot \begin{pmatrix} U_1(s) \\ I_1(s) \end{pmatrix} \qquad (17)$$

Dieser Gleichungssatz (17) beschreibt im Frequenzbereich, wie die Signale $U_{x0}$ und $I_{x0}$ am Vergleichs-Ort $x_0$ aus den Signalen $U_1$ und $I_1$ des ersten Leitungsendes berechnet werden können.

Um die Signale aus den Abtastwertefolgen ermitteln zu können, kann eine Transformation der Gleichungen in den z-Bereich erfolgen. Das wird exemplarisch an der Prädiktionsgleichung zur Ermittlung des geschätzten Vergleichs-Stromes $Ix_0(s)$ am Vergleichs-Ort aus den Strom- und Spannungssignalen $I_1(s)$ und $U_1(s)$ des ersten Leitungsendes gezeigt:

$$i_{x0}(z) = Y_c(z) \cdot G_1(z) \cdot u_1(z) + G_2(z) \cdot i_1(z) \qquad (18)$$

Die in Gleichung (18) verwendeten Übertragungsfunktionen sind hierbei wie folgt definiert:

$$G_1(z) = F^{-1}\{\sinh(\gamma(s) \cdot x_0\} \qquad (19)$$

$$G_2(z) = F^{-1}\{\sinh(\gamma(s) \cdot x_0\} \qquad (20)$$

$$Y_c(z) = F^{-1}\left\{\frac{1}{Z_c(s)}\right\} \qquad (21)$$

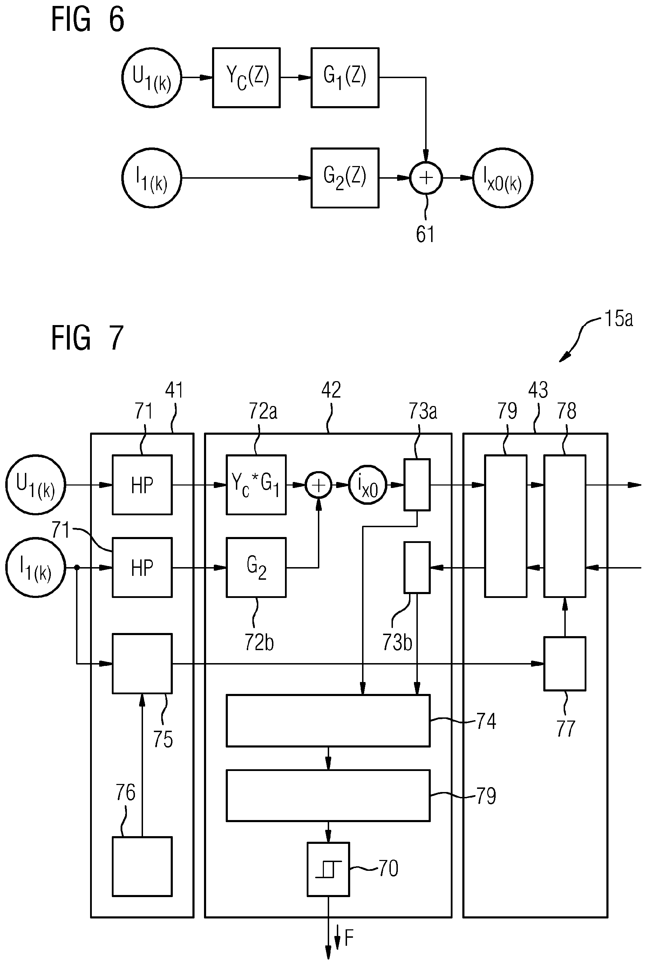

Vorteilhaft lassen sich die die Ausbreitungskonstante $\gamma$ berücksichtigenden Übertragungsfunktionen $G_1(z)$ und $G_2(z)$ durch ein FIR-Filter und die die Wellenimpedanz $Z_C$ berücksichtigende Übertragungsfunktion $Y_C(z)$ durch ein IIR-Filter abbilden. Somit kann der geschätzte Vergleichs-Strom am Vergleichs-Ort der Leitung aus dem Strom- und Spannungssignal vom ersten Leitungsende mithilfe einer logischen Anordnung wie in Figur 6 dargestellt bestimmt werden. Die Blöcke $Y_C(z)$, $G_1(z)$ und $G_2(z)$ stellen hier eine Realisierung der Gleichungen 18-21 dar und bilden den Vergleichs-Stromwert $i_{x0}$ am gemeinsamen Vergleichs-Ort $x_0$ vom ersten Leitungsende aus gesehen. Der geschätzte Vergleichs-Strom $i_{x0}$ am Vergleichs-Ort $x_0$ wird aus den am ersten Leitungsende gemessenen Strom- und Spannungswerten $i_1$ und $u_1$ durch Anwendung der Übertragungsfunktionen $G_1(z)$ und $G_2(z)$ sowie $Y_C(z)$ (z.B. durch Filterung) und Addition in einem Addierer 61 gebildet. Die logische Anordnung gemäß Figur 6 kann dabei in Form einer Hardware oder einer von einem Prozessor ausgeführten Software in dem Schutzgerät 15a implementiert sein.

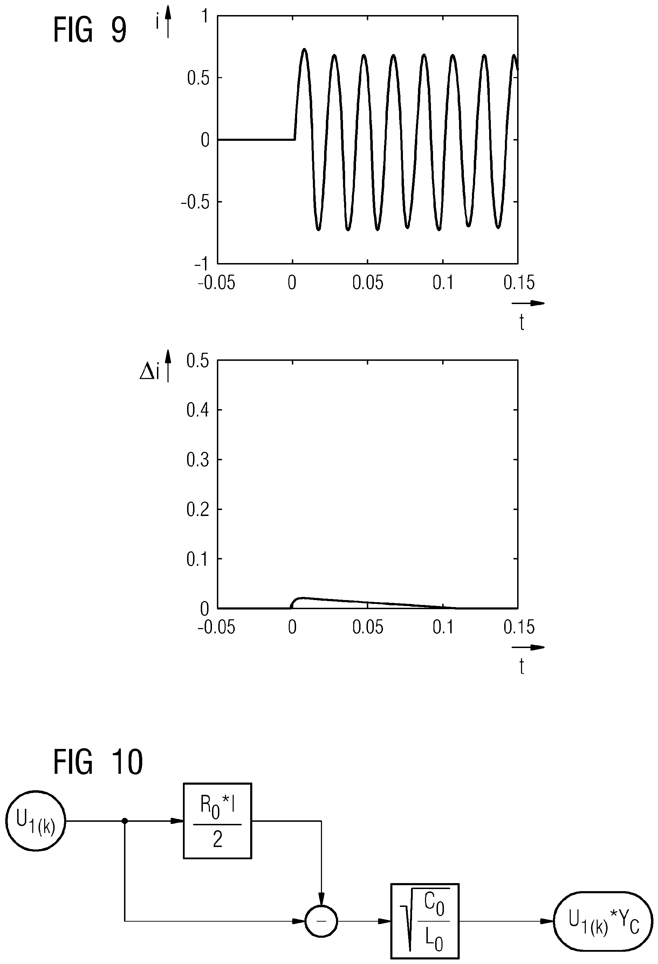

Die Übertragungsfunktion $Y_C(z)$ kann nach beispielsweise mittels eines Least Squares Schätzers aus dem Frequenzgang der Wellenimpedanz $Z_C$ berechnet werden. Kann auf eine Modellierung der Frequenzabhängigkeit der der Parameter R', G', L' und C' verzichtet werden und kann der Leitwert G' als sehr klein angenommen werden (das ist für Frequenzen unterhalb von 50kHz und Freileitungen immer der Fall), dann kann das Faltungsprodukt von $Y_C$ mit der lokalen Spannung der Leitung auch mit einer beispielhaft in Figur 10 gezeigten Anordnung gebildet werden. Die Übertragungsfunktionen $G_1$ und $G_2$ können aus den Termen der hyperbolischen Funktionen mit dem Argument $\gamma l$ durch inverse FFT gebildet werden.

Somit wird gemäß Gleichung 18 ein Wanderwellenmodell der Leitung verwendet, um aus den transienten Strom- und Spannungssignalen des lokalen Leitungsendes den Vergleichs-Strom $i_{x0}(k)$ an einem gemeinsamen Vergleichs-Ort auf der Leitung zu berechnen. Die Variable k steht dabei für den k-ten Abtastwert. Anhand der für den gemeinsamen Vergleichs-Ort bestimmten Vergleichs-Ströme aller Leitungsenden kann daraufhin auf das Vorliegen eines Fehlers geschlossen werden.

Der gemeinsame Vergleichs-Ort kann bei einer 2-Enden Leitung (vgl. Figur 1) beispielsweise die Mitte der Leitung oder das jeweils andere Ende der Leitung sein. Bei einer 3-Enden Leitung (vgl. Figur 2) ist dieser gemeinsame Vergleichs-Ort bevorzugt der Punkt der Leitung, an dem die T-Leitung abzweigt. Entsprechend kann bei Leitungen mit mehr als drei Enden der Vergleichs-Ort an einem der Knotenpunkte festgelegt werden.

Mit zur Messung verwendeten Datenfenstern von ca. 1-2 ms Dauer kann ausreichend genau eine Fehlergröße A für die Leitung gebildet werden, anhand der das Vorliegen eines Fehlers beurteilt werden kann. Die Fehlergröße kann beispielsweise gemäß der folgenden Formel gebildet werden:

$$A = \sqrt{\frac{\sum_{j=0}^{M}\left(\sum_{T=1}^{N}\left(i_{x0}^T(k-j)\right)\right)^2}{P \cdot \sum_{j=0}^{M}\sum_{T=1}^{N}\left(i_{x0}^T(k-j)\right)^2 + P_0}} \qquad (19)$$

In der Formel 19 bedeuten

A:      Fehlergröße;
$i_{xo}^T$:   Vergleichs-Strom vom Leitungsende T aus gesehen;
$x_0$:     Vergleichs-Ort auf der Leitung;
M:      Anzahl von Abtastwerten im Datenfenster;
N:      Anzahl der zu berücksichtigenden Leitungsenden;
j:      Zählvariable er Abtastwerte im Datenfenster;
T:      Zählvariable des zu betrachtenden Leitungsendes;
k:      aktueller Abtastwert;
P:      wählbarer Gewichtungsfaktor;
$P_0$:     wählbarer Stabilisierungswert.

Die vorgeschlagene Fehlergröße verwendet die Vergleichs-Ströme, die mittels Messungen an den jeweiligen Leitungsenden für den gemeinsamen Vergleichs-Ort x0 bestimmt worden sind. Sie weist im Nenner eine "Haltekomponente", die durch Quadrieren und Aufsummieren der einzelnen Vergleichs-Ströme gebildet wird. Als Ergebnis entsteht als Haltekomponente die Summe der Effektivwerte der von den Enden vorhergesagten Vergleichs-Ströme, gewichtet mit einem Faktor P und stabilisiert mit einem Faktor P0. In ihrem Zähler weist die vorgeschlagene Fehlergröße eine "Auslösekomponente" auf, die durch vorzeichenrichtige Addition und anschließendes Quadrieren der einzelnen Vergleichs-Ströme gebildet wird. Die vorzeichenrichtige Addition der Vergleichs-Ströme im Zähler der Fehlergröße A sollte bei einer fehlerfreien Leitung einen Wert nahe Null ergeben. Im Fall eines Fehlers auf der Leitung stimmt das verwendete Vorhersagemodell nicht mehr mit der realen Leitung überein und der Vorhersagefehler ist nicht mehr Null. Die Formel zur Berechnung der Auslösesignals A liefert ein dem Vorhersagefehler proportionales Signal. Wenn A einen Wert erreicht, der oberhalb eines vorgegebenen Schwellenwertes liegt, wird auf einen Fehler auf der zu schützenden Leitung geschlossen. Der Schwellenwert kann bevorzugt den Wert 1 annehmen.

In der Fehlergröße A repräsentiert ix0T(k-j) den vom Leitungsende T aus berechneten Augenblickswert des Vergleichs-Stroms am gemeinsamen Vergleichs-Ort ausgehend vom aktuellen Abtastwert k um j Abtastwerte verzögert. Der Wert M repräsentiert die Länge des Datenfensters. Der Wert N repräsentiert die Anzahl der berücksichtigten Leitungsenden.

In Figur 7 ist ein Blockschaltbild eines Schutzgerätes 15a in detaillierter Ansicht dargestellt. Der Aufbau der Schutzgeräte 15b, 15c kann entsprechend sein.

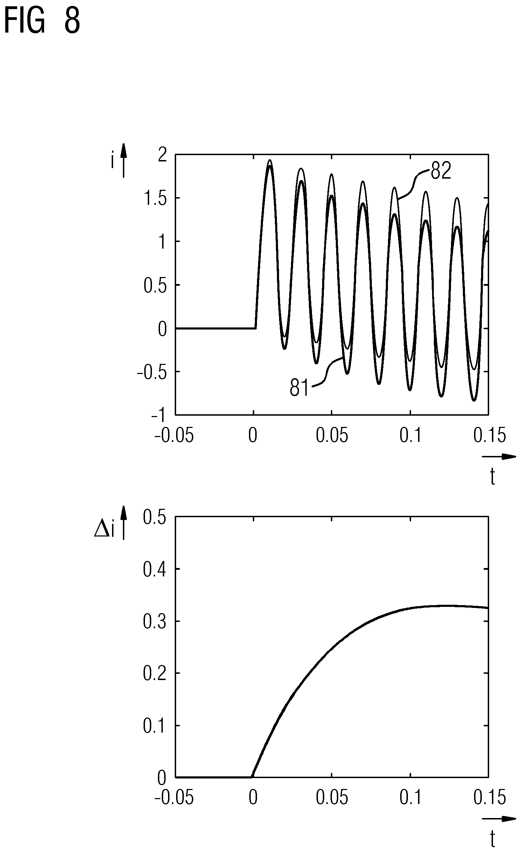

Wie bereits zu Figur 4 beschrieben, umfasst das Schutzgerät 15a eine Messeinrichtung 41, eine Auswerteinrichtung 42 und eine Kommunikationseinrichtung 43. Der Messeinrichtung 41 werden lokal erfasste Messsignale von Strömen und Spannungen zugeführt und in Strom- und Spannungswerte umgesetzt. Die lokalen Eingangssignale $u_1(k)$ und $i_1(k)$ werden dabei bevorzugt mittels eines Hochpassfilters 71 gefiltert. In Figuren 8 und 9 ist beispielhaft die Wirkung eines Hochpasses 1.Ordnung auf die Stromsignale zweier Leitungsenden sowie den Differenzstrom dargestellt. Der Hochpassfilter habe die Nennfrequenz als Knickfrequenz. Durch eine unterschiedliche Zeitkonstante der Primärwandler im Signalzweig entstehen bei der Strom- und Spannungsmessung an den einzelnen Leitungsenden unterschiedliche Gleichstrom-Komponenten in den Sekundärsignalen der Primärwandler. Im Beispiel der Figur 8 ist mittels der Kurve 81 das Verhalten eines linearisierten Wandlers und in der Kurve 82 das Verhalten eines Ringkernwandlers dargestellt. Das Differenzsignal $\Delta i$ der Augenblickswerte beider Wandler würde mehr als 30% Differenzstrom bezogen auf die Amplitude des Stromsignals zur Folge haben. Wie sich in Figur 9 erkennen lässt, lässt sich für dieselben Wandler selbst mit der einfachen Hochpassfilterung 1. Ordnung der Differenzstrom bereits auf ca. 2% absenken. Damit kann der Einfluss unterschiedlicher Wandler in den Augenblickswerten durch Hochpassfilterung fast vollständig eliminiert werden.

Die gefilterten Strom- und Spannungswerte werden an die Auswerteinrichtung 42 übergeben und dort in den Blöcken 72a und 72b mittels digitaler Filterung wie zu Figur 6 beschrieben verarbeitet. Durch Addition der Filterergebnisse wird der Vergleichs-Strom $i_{x0}$ bestimmt.

Der lokal ermittelte Vergleichs-Stromwert $i_{x0}$ wird an einen Sende-Pufferspeicher 73a übergeben. Von dort wird er einerseits an die Kommunikationseinrichtung 43 übergeben, um an die anderen Schutzgeräte 15b, 15c übertragen zu werden. Andererseits wird er einer Interpolationseinrichtung 74 zugeführt.

Außerdem wird der Vergleichs-Stromwert mit einem Zeitstempel der lokalen Relativzeit des Schutzgerätes 15a versehen und auf die Zeitachse der Master Clock der z.B. mittels des PTP-Protokolls zwischen den Schutzgeräten 15a, 15b, 15c synchronisiert gehaltenen gemeinsamen Absolutzeit abgebildet. Zur Bestimmung des Zeitstempels der Abtastwerte in der lokalen Relativzeit wird ein Hardware-Latch 75 verwendet, das zum Zeitpunkt der Abtastung der lokalen Abtastwerte den aktuellen Wert der von einem internen Zeitgeber 76 bereitgestellten Geräte-Relativzeit speichert. Da das PTP Protokoll als Bezug zur globalen Zeit im Geräteverbund (sogenannte "Master Clock") ebenfalls die Geräte-Relativzeit des internen Zeitgebers 76 verwendet, kann die lokale Relativzeit des Schutzgerätes 15a auf die globale Zeit der Master Clock im Geräteverbund abgebildet werden. Diese Abbildung wird mittels des Abbildungs-Blocks 77 durchgeführt. Die Wertepaare ix0(k) und die korrespondierende PTP Zeit werden in dem als nächstes zu sendenden Datenblock akkumuliert. Hier können z.B. die Vergleichs-Stromwerte am gemeinsamen Vergleichs-Ort und die zugehörigen Zeitstempel für eine Zeitdauer von 0,5ms gesammelt werden. Ein entsprechendes Telegramm wird mithilfe des IP Netzwerkstacks 79 über einen physikalischen Ethernet Port 78 des Schutzgerätes 15a, z.B. als UDP (User Datagram Protocol) Datenpaket, gesendet. Vorzugsweise wird hierfür eine Multicast-Adresse verwendet, um das Datenpaket an alle übrigen Schutzgeräte 15b, 15c des Differentialschutzsystems gleichzeitig zu versenden. Im Gegenzug werden über den Ethernet Port 78 die Datenpakete der anderen Schutzgeräte 15b, 15c des Differentialschutzsystems empfangen. Alle empfangenen Datenpakete werden in einem Empfangs-Pufferspeicher 73b als Zeit-Strom Wertepaare zur weiteren Verwendung gepuffert.

Über den Ethernet Port 78 wird mit dem Schutzgerät 15a auch das PTP Protokoll durchgeführt, um eine zwischen allen Schutzgeräten 15a, 15b, 15c im Differentialschutzsystem synchrone Absolutzeit zu erhalten. Die grundlegende Funktionsweise des PTP Protokolls ist z.B. im Internet unter dem Link http://www.ni.com/newsletter/50130/en/ erläutert. Voraussetzung für die Verwendung des PTP Protokolls ist die Unterstützung der Hardware-Zeitstempelung des Protokolls durch alle Netzwerkkomponenten 17 (vgl. Figuren 1 und 2), die an der Kommunikation zwischen den Schutzgeräten 15a, 15b, 15c beteiligt sind. Diese Voraussetzung ist in modernen MPLS-Netzwerken (Multiprotocol Label Switching) erfüllt. Viele Netzbetreiber rüsten ihre Netzwerke mit dieser Technik aus. Daher kann von einer hohen Verfügbarkeit der notwendigen Kommunikationsnetze zwischen Umspannwerken ausgegangen werden.

Aus dem Sende-Pufferspeicher 73a und dem Empfangs-Pufferspeicher 73b werden die jeweils zeitgestempelten Vergleichs-Stromwerte dem Interpolator 74 der Auswerteinrichtung 42 bereitgestellt. Da die Zeitpunkte der Abtastung in den Geräten asynchron zueinander sein können, müssen die Vergleichs-Stromwerte auf einen gemeinsamen Bezugs-Zeitpunkt umgerechnet werden. Dazu kann z.B. das in der WO 2015/110150 A1 beschriebene Verfahren zum Resampling von Abtastwerten benutzt werden.

Mit den zeitlich aufeinander angeglichenen Vergleichs-Stromwerten kann nachfolgend in einem Fehlererkennungsblock 79 eine Überprüfung durchgeführt werden, ob auf der Leitung ein Fehler vorliegt. Dazu kann beispielsweise die Gleichung 19 zur Berechnung der Fehlergröße A eingesetzt werden. Überschreitet die Fehlergröße einen Schwellenwert 70, der z.B. den Wert 1 besitzen kann, so wird von der Auswerteinrichtung 42 das Fehlersignal F abgegeben.

Die beschriebene Auswertung kann in jedem Schutzgerät 15a, 15b, 15c des Differentialschutzsystems separat durchgeführt werden. Die lokal erzeigten Fehlersignale dienen dann zur Auslösung des jeweils lokalen Leistungsschalters 12a, 12b, 12c.

Bei dem beschriebenen Ausführungsbeispiel eines Verfahrens zum Erkennen eines Fehlers auf einer Leitung eines elektrischen Energieversorgungsnetzes wird die bisher übliche Kommunikation gegen eine für Wide Area Netzwerke zeitgemäße UDP/IP Kommunikation ausgetauscht. Gleichzeitig wird ein Leitungsmodell auf Wanderwellenbasis eigesetzt, um den Geschwindigkeitsvorteil eines Breitband IP-Netzwerkes bezüglich der im Netzwerk entstehenden kleinen Kommunikations- Latenzzeiten mit dem Geschwindigkeitsvorteil eines mittels Wanderwellen-Leitungsmodells und gleichzeitiger Hochpassfilterung möglich werdenden Augenblickswerts-Stromvergleiches zu kombinieren und somit einen deutlich schnelleren Differentialschutz zu ermöglichen, der die bekannten Nachteile bisheriger Differentialschutzlösungen vermeidet.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Erkennen eines Fehlers auf einer Leitung (11) eines elektrischen Energieversorgungsnetzes, bei dem

   - an einem ersten Leitungsende (11a) der Leitung (11) erste Stromwerte gemessen werden;
   - zumindest an einem weiteren Leitungsende (11b) der Leitung (11) weitere Stromwerte gemessen werden;
   - unter Verwendung der ersten und der weiteren Stromwerte überprüft wird, ob auf der Leitung (11) ein Fehler vorliegt; wobei
   - an dem ersten Leitungsende (11a) der Leitung (11) erste Spannungswerte gemessen werden;
   - an dem zumindest einen weiteren Leitungsende (11b) der Leitung (11) weitere Spannungswerte gemessen werden;
   - mit den an dem ersten Leitungsende (11a) gemessenen ersten Strom- und Spannungswerten erste Vergleichs-Stromwerte ermittelt werden, die den an einem Vergleichs-Ort (18) auf der Leitung (11) fließenden Strom angeben;
   - mit den an dem zumindest einen weiteren Leitungsende (11b) gemessenen weiteren Strom- und Spannungswerten weitere Vergleichs-Stromwerte ermittelt werden, die den an dem Vergleichs-Ort (18) auf der Leitung (11) fließenden Strom angeben; und
   - unter Verwendung der ersten und der weiteren Vergleichs-Stromwerte das Vorliegen eines Fehlers auf der Leitung (11) überprüft wird und ein Fehlersignal erzeugt wird, wenn bei der Überprüfung auf der Leitung (11) vorliegender Fehler erkannt worden ist
   wobei
   - zur Bestimmung der Vergleichs-Stromwerte ein mathematisches Modell der Leitung (11) für den fehlerfreien Fall herangezogen wird; und
   - die Vergleichs-Stromwerte unter Verwendung der ersten und der weiteren Strom- und Spannungswerte sowie des mathematischen Modells der Leitung geschätzt werden, wobei zur Schätzung die Ausbreitung von Wanderwellen entlang der Leitung (11) betrachtet wird;
   **dadurch gekennzeichnet, dass**
   - zur Schätzung der Vergleichs-Stromwerte die ersten und die weiteren Strom- und Spannungswerte einer Filterung unterzogen werden, wobei mit dem Filter eine zumindest von der Ausbreitungskonstante einer Wanderwelle entlang der Leitung (11) und/oder eine von der Wellenimpedanz der Leitung abhängige Übertragungsfunktion nachgebildet wird.

2. Verfahren nach einem der vorangehenden Ansprüche,
   **dadurch gekennzeichnet, dass**

   - unter Verwendung der ersten und der weiteren Vergleichs-Stromwerte eine Fehlergröße gebildet wird; und
   - ein Fehler auf der Leitung (11) erkannt wird, wenn die Fehlergröße einen vorgegebenen Schwellenwert überschreitet.

**3.** Verfahren nach einem der vorangehenden Ansprüche,
**dadurch gekennzeichnet, dass**

- die ersten und die weiteren Strom- und Spannungswerte einer Filterung mit einem Hochpassfilter (71) unterzogen werden.

**4.** Verfahren nach einem der vorangehenden Ansprüche,
**dadurch gekennzeichnet, dass**

- die Ermittlung der Vergleichs-Stromwerte an jedem Leitungsende (11a, 11b) durchgeführt wird; und
- die an den jeweiligen Leitungsenden (11a, 11b) ermittelten Vergleichs-Stromwerte zwischen den Leitungsenden (11a, 11b) über eine IP-basierte Datenkommunikation übertragen werden.

**5.** Verfahren nach Anspruch 4,
**dadurch gekennzeichnet, dass**

- bei einer mehr als zwei Leitungsenden (11a, 11b, 11c) aufweisenden Leitung (11) die Übertragung der Vergleichs-Stromwerte zwischen den Leitungsenden (11a, 11b, 11c) mittels Multicast-Telegrammen erfolgt.

**6.** Verfahren nach einem der vorangehenden Ansprüche,
**dadurch gekennzeichnet, dass**

- den Vergleichs-Stromwerten Zeitstempel zugeordnet werden.

**7.** Verfahren nach Anspruch 6,
**dadurch gekennzeichnet, dass**

- die zur Zeitstempelung an den jeweiligen Leitungsenden (11a, 11b) verwendeten Zeitgeber mittels eines Zeitimpulses eines zentralen Zeitgebers oder eines Zeitsynchronisations-Protokolls, vorzugsweise PTP, synchronisiert werden.

**8.** Verfahren nach einem der vorangehenden Ansprüche,
**dadurch gekennzeichnet, dass**

- die Überprüfung, ob auf der Leitung (11) ein Fehler vorliegt, an jedem Leitungsende (11a, 11b) durchgeführt wird.

**9.** Verfahren nach Anspruch 8,
**dadurch gekennzeichnet, dass**

- an jedem Leitungsende (11a, 11b) Vergleichs-Stromwerte empfangen werden, die an den anderen Leitungsenden (11a, 11b) ermittelt worden sind; und
- die empfangenen Vergleichs-Stromwerte mit den lokal ermittelten Vergleichs-Stromwerten durch eine erneute Abtastung und eine anschließende Interpolation zeitlich aufeinander abgeglichen werden.

**10.** Schutzgerät (15a) zum Erkennen eines Fehlers auf einer Leitung (11) eines elektrischen Energieversorgungsnetzes, wobei das Schutzgerät (15a)

- eine Messeinrichtung (41) aufweist, die zur Erfassung von an einem ersten Leitungsende (11a) der Leitung (11) gemessenen ersten Stromwerten eingerichtet ist;
- eine Kommunikationseinrichtung (43) aufweist, die zum Empfang von zumindest an einem weiteren Leitungsende (11b) der Leitung (11) gemessenen weiteren Stromwerten eingerichtet ist; und
- eine Auswerteinrichtung (42) aufweist, die dazu eingerichtet ist, unter Verwendung der ersten und der weiteren Stromwerte zu überprüfen, ob auf der Leitung (11) ein Fehler vorliegt;
wobei
- die Messeinrichtung (41) dazu eingerichtet ist, an dem ersten Leitungsende (11a) der Leitung (11) gemessene erste Spannungswerte zu erfassen;
- die Kommunikationseinrichtung (43) dazu eingerichtet ist, an dem zumindest einen weiteren Leitungsende (11b) der Leitung (11) gemessene weitere Spannungswerte zu empfangen;

- die Auswerteinrichtung (42) dazu eingerichtet ist, mit den an dem ersten Leitungsende (11a) gemessenen ersten Strom- und Spannungswerten erste Vergleichs-Stromwerte zu ermitteln, die den an einem Vergleichs-Ort (18) auf der Leitung fließenden Strom angeben;

- die Auswerteinrichtung (42) dazu eingerichtet ist, mit den an dem zumindest einen weiteren Leitungsende (11b) gemessenen weiteren Strom- und Spannungswerten weitere Vergleichs-Stromwerte zu ermitteln, die den an dem Vergleichs-Ort (18) auf der Leitung (11) fließenden Strom angeben; und

- die Auswerteinrichtung (42) dazu eingerichtet ist, unter Verwendung der ersten und der weiteren Vergleichs-Stromwerte das Vorliegen eines Fehlers auf der Leitung zu überprüfen (11) und ein Fehlersignal zu erzeugen, wenn bei der Überprüfung auf der Leitung (11) vorliegender Fehler erkannt worden ist; wobei

- die Auswerteinrichtung dazu eingerichtet ist zur Bestimmung der Vergleichs-Stromwerte ein mathematisches Modell der Leitung (11) für den fehlerfreien Fall heranzuziehen und die Vergleichs-Stromwerte unter Verwendung der ersten und der weiteren Strom- und Spannungswerte sowie des mathematischen Modells der Leitung zu schätzen, wobei zur Schätzung die Ausbreitung von Wanderwellen entlang der Leitung (11) betrachtet wird;

**dadurch gekennzeichnet, dass**

- die Auswerteinrichtung außerdem dazu eingerichtet ist, zur Schätzung der Vergleichs-Stromwerte die ersten und die weiteren Strom- und Spannungswerte einer Filterung zu unterziehen, wobei mit dem Filter eine zumindest von der Ausbreitungskonstante einer Wanderwelle entlang der Leitung (11) und/oder eine von der Wellenimpedanz der Leitung abhängige Übertragungsfunktion nachgebildet wird.

11. Schutzsystem (10, 20) zum Erkennen eines Fehlers auf einer Leitung (11) eines elektrischen Energieversorgungsnetzes, wobei das Schutzsystem (10, 20) mindestens zwei Schutzgeräte (15a, 15b) nach Anspruch 13 aufweist, die über eine Kommunikationsverbindung (16) miteinander verbunden sind.

12. Schutzsystem (10, 20) nach Anspruch 11,
**dadurch gekennzeichnet, dass**

- das Schutzsystem (10, 20) zur Erkennung eines Fehlers auf einer Leitung (11) mit mehr als zwei Enden (11a, 11b, 11c) eingerichtet ist; und
- an jedem Ende (11a, 11b, 11c) der Leitung (11) ein Schutzgerät (15a, 15b, 15c) vorgesehen ist, wobei alle Schutzgeräte (15a, 15b, 15c) miteinander über die Kommunikationsverbindung (16) verbunden sind.

## Claims

1. Method for detecting a fault on a line (11) of an electrical power supply system, in which

- first current values are measured at a first line end (11a) of the line (11);
- further current values are measured at least at a further line end (11b) of the line (11);
- the first and the further current values are used to check whether there is a fault on the line (11); wherein
- first voltage values are measured at the first line end (11a) of the line (11);
- further voltage values are measured at the at least one further line end (11b) of the line (11);
- the first current and voltage values measured at the first line end (11a) are used to ascertain first comparison current values indicating the current flowing at a comparison location (18) on the line (11);
- the further current and voltage values measured at the at least one further line end (11b) are used to ascertain further comparison current values indicating the current flowing at the comparison location (18) on the line (11); and
- the first and the further comparison current values are used to check for the presence of a fault on the line (11), and a fault signal is generated if the check has resulted in a fault present on the line (11) being detected, wherein
- the comparison current values are determined by using a mathematical model of the line (11) for the fault-free case; and
- the comparison current values are estimated by using the first and the further current and voltage values and also the mathematical model of the line, wherein the estimation is performed by considering the propagation of travelling waves along the line (11);

**characterized in that**

- the comparison current values are estimated by subjecting the first and the further current and voltage values to a filtering, wherein the filter is used to reproduce a transfer function dependent at least on the propagation constant of a travelling wave along the line (11) and/or a transfer function dependent on the characteristic impedance of the line.

2. Method according to one of the preceding claims, **characterized in that**

- the first and the further comparison current values are used to form a fault magnitude; and
- a fault on the line (11) is detected if the fault magnitude exceeds a prescribed threshold value.

3. Method according to either of the preceding claims, **characterized in that**

- the first and the further current and voltage values are subjected to a filtering using a high-pass filter (71).

4. Method according to one of the preceding claims, **characterized in that**

- the ascertainment of the comparison current values is performed at each line end (11a, 11b); and
- the comparison current values ascertained at the respective line ends (11a, 11b) are transmitted between the line ends (11a, 11b) by means of an IP-based data communication.

5. Method according to Claim 4,
**characterized in that**

- a line (11) having more than two line ends (11a, 11b, 11c) results in the transmission of the comparison current values between the line ends (11a, 11b, 11c) being effected by means of multicast messages.

6. Method according to one of the preceding claims,
**characterized in that**

- the comparison current values are assigned timestamps.

7. Method according to Claim 6,
**characterized in that**

- the timers used for timestamping at the respective line ends (11a, 11b) are synchronized by means of a time pulse of a central timer or a time synchronization protocol, preferably PTP.

8. Method according to one of the preceding claims,
**characterized in that**

- the check to determine whether there is a fault on the line (11) is performed at each line end (11a, 11b).

9. Method according to Claim 8,
**characterized in that**

- comparison current values are received at each line end (11a, 11b) that have been ascertained at the other line ends (11a, 11b); and
- the received comparison current values and the locally ascertained comparison current values are time aligned with one another by means of a renewed sampling and a subsequent interpolation.

10. Protective device (15a) for detecting a fault on a line (11) of an electrical power supply system, wherein the protective device (15a)

- has a measuring device (41) set up for recording first current values measured at a first line end (11a) of the line (11);
- has a communication device (43) set up for receiving further current values measured at least at a further line end (11b) of the line (11); and
- has an evaluation device (42) set up to use the first and the further current values to check whether there is a fault on the line (11);

wherein

- the measuring device (41) is set up to record first voltage values measured at the first line end (11a) of the line (11);
- the communication device (43) is set up to receive further voltage values measured at the at least one further line end (11b) of the line (11);
- the evaluation device (42) is set up to use the first current and voltage values measured at the first line end (11a) to ascertain first comparison current values indicating the current flowing at a comparison location (18) on the line;
- the evaluation device (42) is set up to use the further current and voltage values measured at the at least one further line end (11b) to ascertain further comparison current values indicating the current flowing at the comparison location (18) on the line (11); and
- the evaluation device (42) is set up to use the first and the further comparison current values to check for the presence of a fault on the line (11) and to generate a fault signal if the check has resulted in a fault present on the line (11) being detected; wherein
- the evaluation device is set up to determine the comparison current values by using a mathematical model of the line (11) for the fault-free case and to estimate the comparison current values by using the first and the further current and voltage values and also the mathematical model of the line, wherein the estimation is performed by considering the propagation of travelling waves along the line (11);
**characterized in that**
- the evaluation device is also set up to estimate the comparison current values by subjecting the first and the further current and voltage values to a filtering, wherein the filter is used to reproduce a transfer function dependent at least on the propagation constant of a travelling wave along the line (11) and/or a transfer function dependent on the characteristic impedance of the line.

**11.** Protective system (10, 20) for detecting a fault on a line (11) of an electrical power supply system, wherein the protective system (10, 20) has at least two protective devices (15a, 15b) according to Claim 13 connected to one another via a communication connection (16).

**12.** Protective system (10, 20) according to Claim 11, **characterized in that**

- the protective system (10, 20) is set up to detect a fault on a line (11) having more than two ends (11a, 11b, 11c); and
- a protective device (15a, 15b, 15c) is provided at each end (11a, 11b, 11c) of the line (11), wherein all of the protective devices (15a, 15b, 15c) are connected to one another via the communication connection (16).


**Revendications**

**1.** Procédé de détection d'un défaut sur une ligne (11) d'un réseau d'alimentation en énergie électrique, dans lequel

- on mesure des premières valeurs de courant à un premier bout (11a) de la ligne (11) ;
- on mesure d'autres valeurs de courant à au moins un autre bout (11b) de la ligne (11) ;
- en utilisant les premières et les autres valeurs de courant, on contrôle s'il y a un défaut sur la ligne (11) ; dans lequel
- on mesure des premières valeurs de tension au premier bout (11a) de la ligne (11) ;
- on mesure d'autres valeurs de tension au au moins un autre bout (11b) de la ligne (11) ;
- par les premières valeurs de courant et de tension mesurées au premier bout (11a) de ligne, on détermine des premières valeurs de courant de comparaison, qui indiquent le courant passant à un emplacement (18) de comparaison sur la ligne (11) ;
- par les autres valeurs de courant et de tension mesurées au au moins un autre bout (11b) de la ligne, on détermine d'autres valeurs de courant de comparaison, qui indiquent le courant passant à l'emplacement (18) de comparaison sur la ligne (11) ; et
- en utilisant les premières et les autres valeurs de courant de comparaison, on contrôle la présence d'un défaut sur la ligne (11), et on produit un signal de défaut, s'il a été reconnu, lors de la comparaison, un défaut présent sur la ligne (11),
dans lequel
- pour la détermination des valeurs de courant de comparaison, on tire parti d'un modèle mathématique de la ligne (11) pour le cas sans défaut ; et

- on évalue les valeurs de courant de comparaison en utilisant les premières et les autres valeurs de courant et de tension ainsi que le modèle mathématique de la ligne, dans lequel, pour l'estimation, on considère la propagation d'ondes progressives le long de la ligne (11) ;
**caractérisé en ce que**
- pour l'estimation des valeurs de courant de comparaison, on soumet les premières et les autres valeurs de courant et de tension à un filtrage, dans lequel, par le filtre, on reproduit une fonction de transfert, qui dépend au moins de la constante de propagation d'une onde progressive le long de la ligne (11) et/ou de l'impédance d'onde de la ligne.

2. Procédé suivant la revendication précédente,
**caractérisé en ce qu'**

- en utilisant les premières et les autres valeurs de courant de comparaison, on forme une grandeur de défaut ; et
- on détecte un défaut sur la ligne (11), si la grandeur de défaut dépasse une valeur de seuil donnée à l'avance.

3. Procédé suivant l'une des revendications précédentes,
**caractérisé en ce qu'**

- on soumet les premières et les autres valeurs de courant et de tension à un filtrage par un filtre (71) passe haut.

4. Procédé suivant l'une des revendications précédentes,
**caractérisé en ce qu'**

- on effectue la détermination des valeurs de courant de comparaison à chaque bout (11a, 11b) de la ligne ; et
- on transmet les valeurs de courant de comparaison déterminées aux bouts (11a, 11b) respectifs de la ligne entre les bouts (11a, 11b) de la ligne par une communication de données sur la base de IP.

5. Procédé suivant la revendication 4,
**caractérisé en ce que**

- pour une ligne (11) comportant plus de deux bouts (11a, 11b, 11c) de ligne, la transmission des valeurs de comparaison entre les bouts (11a, 11b, 11c) de la ligne s'effectue au moyen de télégrammes multicasts.

6. Procédé suivant l'une des revendications précédentes,
**caractérisé en ce que**

- l'on affecte un horodatage aux valeurs de courant de comparaison.

7. Procédé suivant la revendication 6,
**caractérisé en ce qu'**

- au moyen d'une impulsion temporelle d'une horloge centrale ou d'un protocole de synchronisation temporelle, de préférence PTP, on synchronise les horloges utilisées pour l'horodatage aux bouts (11a, 11b) respectifs de la ligne.

8. Procédé suivant l'une des revendications précédentes,
**caractérisé en ce qu'**

- on effectue le contrôle du point de savoir s'il y a un défaut sur la ligne (11) à chaque bout (11a, 11b) de la ligne.

9. Procédé suivant la revendication 8,
**caractérisé en ce qu'**

- on reçoit, à chaque bout (11a, 11b) de la ligne, des valeurs de courant de comparaison, qui ont été déterminées aux autres bouts (11a, 11b) de la ligne ; et
- on égalise les unes avec les autres temporellement les valeurs de courant de comparaison reçues avec les valeurs de courant de comparaison déterminées localement par un échantillonnage renouvelé et une interpolation venant ensuite.

**10.** Appareil (15a) de protection pour la détection d'un défaut sur une ligne (11) d'un réseau d'alimentation en énergie électrique, dans lequel l'appareil (15a) de protection

- a un dispositif (41) de mesure, qui est agencé pour la détection de premières valeurs de courant mesurées à un premier bout (11a) de la ligne (11) ;
- a un dispositif (43) de communication, qui est agencé pour la réception d'autres valeurs de courant mesurées au moins à un autre bout (11b) de la ligne (11) ; et
- a un dispositif (42) d'analyse, qui est conçu pour, en utilisant les premières et les autres valeurs de courant, contrôler s'il y a un défaut sur la ligne (11) ;
dans lequel
- le dispositif (41) de mesure est agencé pour détecter des premières valeurs de tension au premier bout (11a) de la ligne (11) ;
- le dispositif (43) de communication est agencé pour recevoir d'autres valeurs de tension mesurées au moins à un autre bout (11b) de la ligne (11) ;
- le dispositif (42) d'analyse est agencé pour déterminer, par les premières valeurs de courant et de tension mesurées au premier bout (11a) de la ligne, des premières valeurs de courant de comparaison, qui indiquent le courant passant sur la ligne à un emplacement (18) de comparaison ;
- le dispositif (42) d'analyse est agencé pour déterminer, par les autres valeurs de courant et de tension mesurées à au moins un autre bout (11b) de la ligne, d'autres valeurs de courant de comparaison, qui indiquent le courant passant à l'emplacement (18) de comparaison sur la ligne (11) ; et
- le dispositif (42) d'analyse est agencé pour, en utilisant les premières et les autres valeurs de courant de comparaison, contrôler la présence d'un défaut sur la ligne (11) et produire un signal de défaut, si, lors du contrôle, il a été reconnu un défaut présent sur la ligne (11) ; dans lequel
- le dispositif d'analyse est agencé pour tirer parti, pour la détermination des valeurs de courant de comparaison, d'un modèle mathématique de la ligne (11) pour le cas sans défaut et pour estimer les valeurs de courant de comparaison en utilisant les premières et les autres valeurs de courant de tension, ainsi que le modèle mathématique de la ligne, dans lequel, pour l'estimation, on prend en considération la propagation d'ondes progressives le long de la ligne (11) ;
**caractérisé en ce que**
- le dispositif d'analyse est agencé en outre pour soumettre, pour l'estimation des valeurs de courant de comparaison, les premières et les autres valeurs de courant et de tension à un filtrage, dans lequel, par le filtre, on reproduit une fonction de transfert, qui dépend au moins de la constante de propagation d'une onde progressive le long de la ligne (11) et/ou de l'impédance d'onde de la ligne.

**11.** Système (10, 20) de protection de détection d'un défaut sur une ligne (11) d'un réseau d'alimentation en énergie électrique, dans lequel le système (10, 20) de protection a au moins deux appareils (15a, 15b) de protection suivant la revendication 13, qui sont reliés entre eux par une liaison (16) de communication.

**12.** Système (10, 20) de protection suivant la revendication 11, **caractérisé en ce que**

- le système (10, 20) de protection est agencé pour la détection d'un défaut sur une ligne (11) ayant plus de deux bouts (11a, 11b, 11c) ; et
- il est prévu, à chaque bout (11a, 11b, 11c) de la ligne (11), un appareil (15a, 15b, 15c) de protection, dans lequel tous les appareils (15a, 15b, 15c) de protection sont reliés entre eux par la liaison (16) de communication.

FIG 1

# FIG 2

## FIG 3

## FIG 4

FIG 5

EP 3 477 808 B1

# FIG 6

$U_{1(k)}$ → $Y_C(Z)$ → $G_1(Z)$

$I_{1(k)}$ → $G_2(Z)$ → (+) → $I_{x0(k)}$

61

# FIG 7

15a

71    41          72a          42          73a          79    43    78

$U_{1(k)}$ → HP → $Y_C*G_1$ → (+) → $i_{x0}$ →

71

$I_{1(k)}$ → HP → $G_2$

72b          73b

75

76

74

79

70

F

# FIG 8

FIG 9

FIG 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1236259 B1
- EP 3477808 A1
- US 2015233976 A
- US 2017199237 A
- WO 2015110150 A1